# EUROPEAN PATENT SPECIFICATION

(11) **EP 1 225 621 B1**
(45) Date of publication and mention of the grant of the patent: **13.07.2011**
(21) Application number: 00954910.6
(22) Date of filing: 23.08.2000
(51) Int. Cl.: H01L 21/3065

(54) **METHOD OF ETCHING**
ÄTZMETHODE
PROCEDE D'ATTAQUE CHIMIQUE

(30) Priority: 23.08.1999 JP 23519199
(43) Date of publication of application: 24.07.2002
(73) Proprietor: TOKYO ELECTRON LIMITED, Minato-ku Tokyo 107-8481 (JP)
(72) Inventor: KOBAYASHI, Ken, Tokyo Electron America, Inc., Suite 300, Santa Clara, CA 95054 (US); HAGIHARA, Masaaki, Tokyo Electron Massachusetts, Beverly, MA 01915 (US); NAITO, Wakako, Tokyo Electron AT Limied, Nirasaki-shi, Yamanashi 407-0003 (JP); INAZAWA, Koichiro, Tokyo Electron Yamanashi Ltd., Nirasaki-shi, Yamanashi 407-0003 (JP)
(74) Representative: Goddar, Heinz J.
(86) International application number: PCT/JP2000/005623
(87) International publication number: WO 2001/015213

(56) References cited:
- EP-A- 1 030 353
- WO-A-99/26277
- WO-A-99/33096
- JP-A- 10 209 118
- JP-A- 11 150 101
- JP-A- 60 170 238
- JP-A- 2000 036 484
- JP-A- 2000 294 633
- US-A- 4 529 860
- TACITO R D ET AL: "Fine-line patterning of parylene-n by reactive ion etching for application as an interlayer dielectric" JOURNAL OF THE ELECTROCHEMICAL SOCIETY, ELECTROCHEMICAL SOCIETY. MANCHESTER, NEW HAMPSHIRE, US, vol. 143, no. 6, June 1996 (1996-06), pages 1974-1977, XP002087806 ISSN: 0013-4651

## Description

### TECHNICAL FIELD OF THE INVENTION

The present invention relates to a method of etching.

In the following, the unit Torr is used. It equals 133Pa. The Angström (Å) equals 0,1nm.

### BACKGROUND ART

Conventionally, in using Al alloy for the wiring of semiconductor element, the wiring pattern is formed by depositing the Al alloy by spattering on a layer insulating film and then by etching. In this conventional dry-method of etching, the pressure in a process chamber is generally several to 100 mTorr. According to JP60-170238, the maximum etching speed can be achieved at 50-100 mTorr.

On the other hand, the Cu wiring formation called damascene process is made recently. The damascene process is a method for forming the groove of wiring pattern on the layer insulating film and embedding the wiring material in the groove. The specific resistance becomes halved and the etching speed can be easily high by changing the wiring material from Al alloy to Cu. Since flattening can be easily achieved by Chemical Mechanical Polishing (CMP) recently, the damascene process has become easy to be utilized.

Also, there is a technology called dual damascene as the applied technology of the damascene process. The dual damascene is a technology of forming a wiring and a via hole at the same time by forming an inverted convex groove on which the wiring and the via hole are formed in the later step and by embedding metal substance for wiring in the groove. In forming the inverted convex groove for the dual damascene, it is necessary to control so that the bottom of the formed groove may be made flat when the etching is stopped before the etching goes through the layer insulating film.

However, there are the following problems: when the inverted convex groove for the dual damascene is formed at the conventional pressure range of several to 100 mTorr, the bottom of the groove cannot be made flat and so-called micro trenching is occurred; and the selectivity for the etching mask (hereafter, referred to as "mask selectivity") is low.

To prevent the micro trenching, a layer as a ground (hereafter, referred to as an "etch stop") is formed at a desired depth. However, since the etch stop has a high dielectric constant, a capacitor is formed between the wirings. In the most advanced technology with increasingly fine wirings, there is an urgent need to develop a method of etching capable of preventing micro trenching without using an etch stop.

WO-A-99/26 277 discloses a process for etching an organic layer on a substrate placed within an inductively-coupled plasma machine, the process using a mixture of H2 and N₂ gas and a chamber pressure between 600 mTorr and 2,5 Torr.

The present invention has been achieved in views of aforementioned problems. The first object of the present invention is to provide a novel and improved method of etching capable of preventing micro trenching without using an etch stop.

Further the second object of the present invention is to provide a novel and improved method of etching capable of improving mask selectivity.

### DISCLOSURE OF THE INVENTION

According to the invention to achieve the above objects, there is provided a method with the features of claim 1. Subject matter of the sub claims are preferred embodiments of the invention.

If the process gas includes at least nitrogen atoms and hydrogen atoms and a pressure in the process chamber is set substantially higher than 500 mTorr, micro trenching can be prevented without using an etch stop and mask selectivity can be improved. Therefore, the effect can be achieved especially in the process with the necessity to stop etching before the etching goes through the organic film, for example, dual damascene process and the like.

In addition, N₂ can be adopted as the gas including nitrogen atoms and H₂ as hydrogen atoms. If N₂ and H₂ are adopted as the component of the process gas as this, the process gas can be easily treated and will not easily cause greenhouse warming even if the process gas is released to atmosphere. Furthermore, since N₂ and H₂ are cheap, the cost for process will not increase.

Also, if the process gas includes Ar, the control of the groove shape can be facilitated.

### BRIEF DESCRIPTION OF THE DRAWINGS

FIG. 1 is a schematic sectional view of an etching apparatus that may adopt the present invention;
FIG. 2 schematically illustrates an implementation example 1 of the present invention;
FIG. 3 schematically illustrates an implementation example 2 of the present invention;
FIG. 4 is a schematic sectional view of another etching apparatus that may adopt the present invention; and
FIG. 5 schematically illustrates an implementation example 3 of the present invention.

### BEST MODE FOR CARRYING OUT THE INVENTION

The following is a detailed explanation of preferred implementation examples of the method of etching according to the present invention, given in reference to the attached drawings. It is to be noted that in this specification and the drawings, the same reference numbers are assigned to components achieving essentially identical functions and structural features to preclude the necessity for repeated explanation thereof.

### (1) Structure of etching apparatus

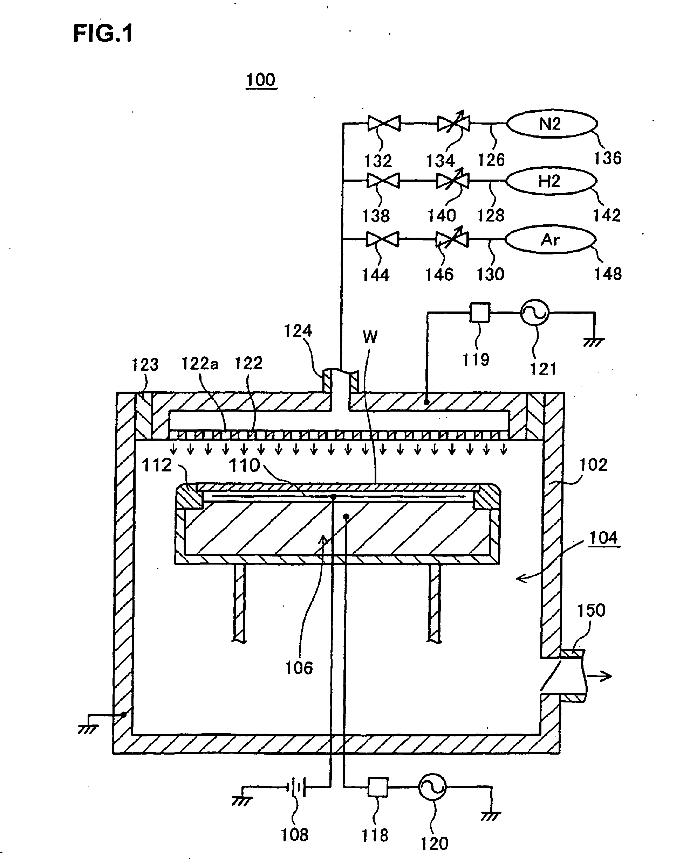

First, in reference to FIG. 1, an etching apparatus 100 that may adopt the method of etching in the implementation example is explained.

Inside a process container 102 of the etching apparatus 100 in the figure, a process chamber 104 is formed, and inside the process chamber 104, a lower electrode 106 constituting a susceptor capable of moving up and down freely is provided. At the top of the lower electrode 106, an electrostatic chuck 110 connected to a high-voltage DC source 108 is provided, and a workpiece such as a semiconductor wafer (hereafter referred to as a "wafer") W is placed on the upper surface of the electrostatic chuck 110. In addition, a focus ring 112 achieving an insulating property is provided around the wafer W placed on the lower electrode 106. A high-frequency source 120 is connected to the lower electrode 106 via a matcher 118.

At the ceiling of the process chamber 104 facing opposite the mounting surface of the lower electrode 106, an upper electrode 122 having numerous gas outlet holes 122a is provided. An insulator 123 is provided between the upper electrode 122 and the process container 102. A high-frequency source 121 that outputs plasma generating high-frequency power is connected to the upper electrode 122 via a matcher 119. A gas supply pipe 124 is connected to the gas outlet holes 122a, and in the example shown in the figure, first - third branch pipes 126, 128 and 130 are connected to the gas supply pipe 124.

A gas supply source 136 that supplies N₂ is connected to the first branch pipe 126 via an open/close valve 132 and a flow-rate regulating valve 134. A gas supply source 142 that supplies H₂ is connected to the second branch pipe 128 via an open/close valve 138 and a flow-rate regulating valve 140. A gas supply source 148 that supplies Ar is connected to the third branch pipe 130 via an open/close valve 144 and a flow-rate regulating valve 146. The inert gas added into the process gas is not limited to Ar in the example above and any inert gas including He and Kr may be used instead, as long as it can be utilized to adjust the plasma excited inside the process chamber 104.

In addition, near the bottom of the process container 102, a gas discharge pipe 150 which communicates with a vacuum drawing mechanism (not shown) is connected, and through the function of the vacuum drawing mechanism, the atmosphere inside the process chamber 104 is sustained at a specific reduced pressure.

### (2) Structure of wafer

Next, the structure of the wafer W to undergo the etching process through the method of etching in the implementation example is explained.

The wafer W used in the implementation example has a layer insulating film to undergo the etching process formed on a Cu layer. The layer insulating film is made from an organic material with low-dielectric constant much lower than a conventional SiO₂ film in the relative dielectric constant such as polyorganosiloxane-bridged benzocyclobutene resin (hereafter, referred to as "BCB"), DowChemical-made SiLK (trade name) and FLARE (trade name) which has the following structure.

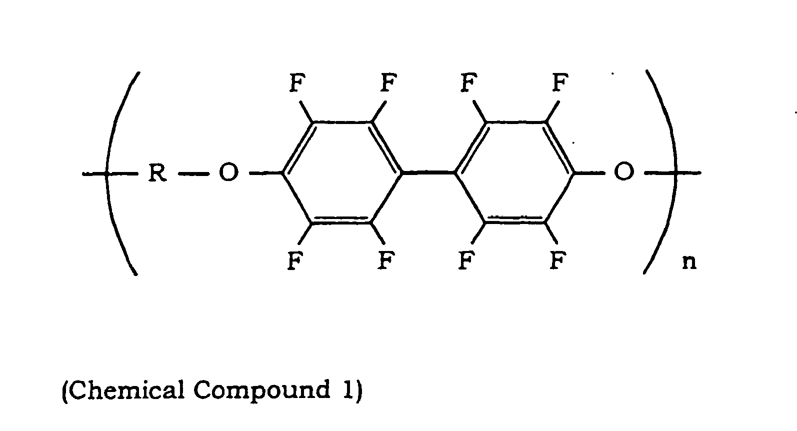

In addition, an etching mask having a specific pattern is formed on the layer insulating film. This etching mask may be constituted of a photoresist film layer, or SiO₂ film and a photoresist film for instance.

Next, an etching process performed using the etching apparatus 100 described above to form contact holes on the wafer W through the method of etching in the implementation example is explained.

First, the wafer W is placed on the lower electrode 106 the temperature of which has been preset to a specific level, and the temperature of the wafer W is sustained at approximately 20°C ∼ 60°C in conformance to particular requirements of the process. Next, the process gas in the implementation example, i.e., the process gas achieved by mixing N₂, H₂ and Ar, is induced into the process chamber 104 while adjusting the flow rates of the individual gases through the flow-rate regulating valves 134, 140 and 146 inserted at the gas supply pipe 124. During this process, vacuum drawing is implemented inside the process chamber 104 to achieve a specific pressure level for the atmosphere inside the process chamber 104, which will correspond the requirements of the process, substantially at higher than 500mTorr, more preferably 500-800 mTorr.

Next, high-frequency power with a frequency of 2 MHz and a power level of 600-1400 W, for instance, is applied to the lower electrode 106. In addition, high-frequency power with a frequency of 60 MHz and a power level of 600-1400 W, for instance, is applied to the upper electrode 122. As a result, high density plasma is generated inside the process container 102 and contact holes achieving a specific shape are formed at the layer insulating film of wafer W constituting of an organic material with low-dielectric constant with the plasma.

This implementation example is configured as described above. Since the process gas includes at least nitrogen atoms and hydrogen atoms under a pressure substantially higher than 500 mTorr in the process chamber, micro trenching can be prevented without using an etch stop. Mask selectivity is also improved.

Since N₂ and H₂ are adopted as the component of the process gas, the process gas can be easily treated and will not easily cause greenhouse warming even if the process gas is released to atmosphere. Further, since N₂ and H₂ are cheap, the cost for process will not increase. Also, since the process gas includes Ar, the control of the groove shape can be facilitated as the etching condition can be easily controlled. Furthermore, since a specific etching process can be achieved without adding O₂ into the process gas, the oxidization of the Cu layer can be prevented during the process. Consequently, it is not necessary to form an oxidization-prevention film on the Cu film, and workpiece can be relatively thinner.

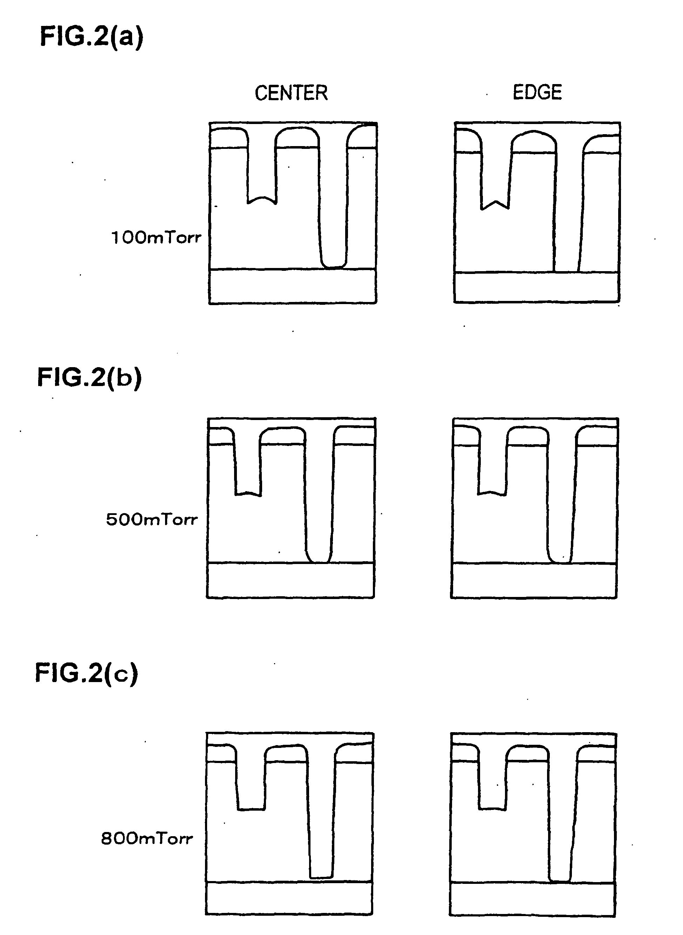

Next, specific implementations of the method of etching according to the present invention are explained in reference to FIGS. 2-5. It is to be noted that since contact holes are formed at the layer insulating film of the wafer W by using the etching apparatus 100 explained in reference to the above implementation example, the same reference numbers are assigned to components of the etching apparatus 100 and the wafer W achieving roughly identical functions and structural features to preclude the necessity for repeated

| Implementation | Flowrate of process gas (sccm) | | | Pressure level for atmosphere in process chamber (mTorr) | Etching rate (Å/m) | | Trenching (%) | | Sectional shape of contact hole |
|---|---|---|---|---|---|---|---|---|---|
| example | N₂ | H₂ | Aᵣ | | center | edge | center | edge | |
| 1 (a) | 400 | 400 | 0 | 100 | 3958 | 4000 | 117 | 120 | Fig. 2 (a) |
| 1(b) | 400 | 400 | 0 | 500 | 3792 | 3354 | 100 | 112 | Fig. 2 (b) |
| 1(c) | 400 | 400 | 500 | 800 | 4043 | 3532 | 87 | 104 | Fig. 2(c) |

explanation thereof in the implementation examples 1 and 2 described later. In addition, unless specifically indicated, the etching process conditions are set virtually the same as those in the implementation example described above.

### (A) Implementation Example 1 (change of pressure level for the atmosphere inside process chamber)

In reference to FIG. 2, implementation examples 1(a)-(c) achieved by changing the pressure level for the atmosphere inside the process chamber 104 are explained.

In example 1(a)-(c), the etching process was performed by basing on the condition as in the following table to form contact holes at the layer insulating film of the wafer W described earlier.

### (Table 1)

It is to be noted that the central part of wafer W is designated as center, the end part of wafer W as edge and the part in the middle of central and end parts as middle in the table and the drawing. Also, trenching is the ratio of the depth of etching at the end part of contact holes to the depth of etching at the roughly central part of contact holes. The more the ratio becomes, the more degree of micro trenching

| Implement ation | Flowrate of process gas (sccm) | | | Pressure level for atmosphere in process chamber (mTorr) | Etching rate (Å/m) | | Trenching (%) | | Sectional shape of contact hole |
|---|---|---|---|---|---|---|---|---|---|
| example | N₂ | H₂ | Aᵣ | | center | edge | center | edge | |
| 2 (a) | 400 | 400 | 0 | 100 | 3063 | 3146 | 157 | 153 | Fig. 3 (a) |
| 2(b) | 400 | 400 | 0 | 500 | 3521 | 3146 | 114 | 126 | Fig. 3 (b) |
| 2(c) | 400 | 400 | 500 | 800 | 3638 | 3426 | 89 | 106 | Fig. 3(c) |

making a bad influence on the shapes of contact holes is made.

In the implementation examples 1(b) and (c) as a result, contact holes with good shapes can be formed without lowering the etching rate, as shown in table 1 and FIGS. 2(b) and (c). In the implementation example 1(a) on the other hand, micro trenching is formed on the contact holes.

### (B) Implementation Example 2 (change of pressure level for the atmosphere inside process chamber)

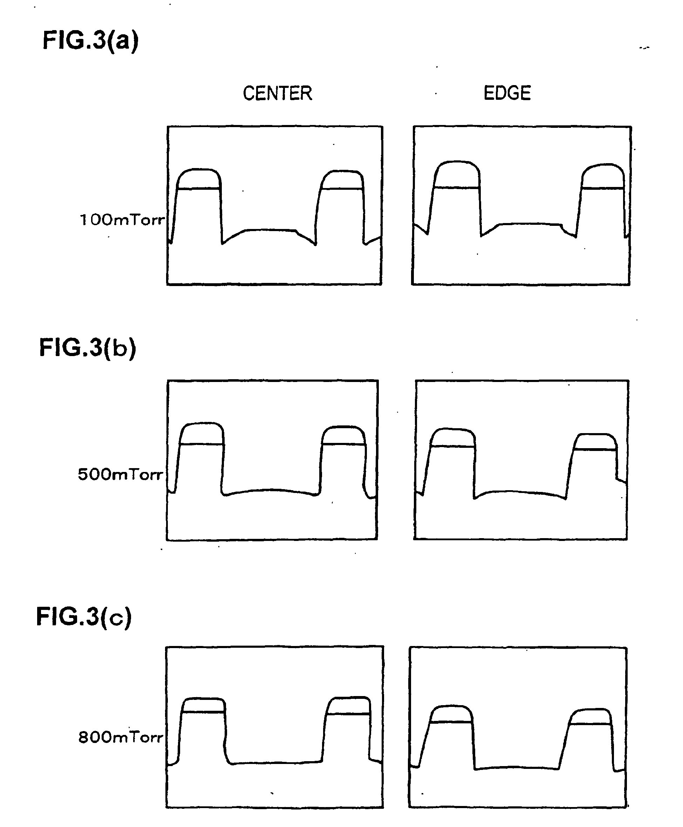

In reference to FIG. 3, implementation examples 2(a)-(c) achieved by changing the pressure level for the atmosphere inside the process chamber 104 are explained. In this implementation example, the width of formed contact hole is changed under the same condition as in the implementation

### (Table 2)

### example 1.

In example 2(a)-(c), the etching process was performed by basing on the condition as in the following table to form contact holes at the layer insulating film of the wafer W described earlier.

In the implementation examples 2(b) and (c) as a result, contact holes with good shapes can be formed without lowering the etching rate, as shown in table 2 and FIGS. 3(b) and (c). In the implementation example 2(a) on the other hand, micro trenching is formed on the contact holes. Judging from the result in this implementation example, if the pressure inside the process chamber is set at a specific level, contact holes with good shapes can be formed even when the width of contact hole is changed.

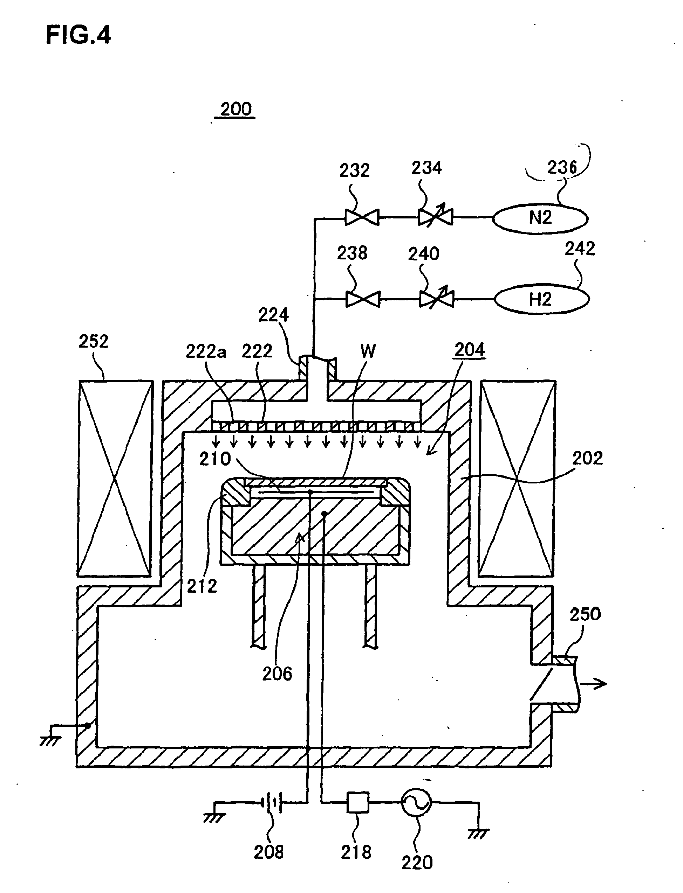

### (C) Implementation Example 3 (change of flow rate of N₂ and H₂) In reference to FIG. 4, implementation example 3 achieved by changing the flow rate of N₂ and H₂ constituting the process gas by using an etching apparatus 200 detailed later is explained.

First, in reference to FIG. 4, an etching apparatus 200 that may adopt the method of etching in the implementation example is explained. Inside a process container 202 of the etching apparatus 200 in the figure, a process chamber 204 is formed, and inside the process chamber 204, a lower electrode 206 constituting a susceptor capable of moving up and down freely is provided. At the top of the lower electrode 206, an electrostatic chuck 210 connected to a high-voltage DC source 208 is provided, and a wafer W is placed on the upper surface of the electrostatic chuck 210. In addition, a focus ring 212 achieving an insulating property is provided around the wafer W placed on the lower electrode 206. A high-frequency source 220 outputting plasma generating high-frequency power is connected to the lower electrode 206 via a matcher 220.

At the ceiling of the process chamber 204 facing opposite the mounting surface of the lower electrode 206, an upper electrode 222 having numerous gas outlet holes 222a is provided. In this implementation example, the upper electrode 222 composes a part of the process container 202. A gas supply pipe 224 is connected to the gas outlet holes 222a as the etching apparatus 100, and in the example shown in the figure, first and second branch pipes 224 and 228 are connected to the gas supply pipe 224.

A gas supply source 236 that supplies N₂ is connected to the first branch pipe 226 via an open/close valve 232 and a flow-rate regulating valve 234. A gas supply source 242 that supplies H₂ is connected to the second branch pipe 228 via an open/close valve 238 and a flow-rate regulating valve 240. It is to be noted that a third branch pipe may be provided to supply

### (Table 3)

### inert gas such as Ar as in the etching apparatus 100.

In addition, near the bottom of the process container 202, a gas discharge pipe 150 as in the etching apparatus 100 is connected. Further, a magnet 238 is arranged covering the outside-wall of the process container 202 outside the process chamber 204. A gyromagnetic field is formed in the plasma region located between the upper electrode 222 and the lower electrode 206.

In this implementation example, the temperature of the wafer W is sustained approximately at 20°C ∼ 80°C. And then high-frequency power with a frequency of 13.56 MHz and a power level of 500-1500 W, for instance, is applied to the lower electrode 206

In example 3(a)-(d), the etching process was performed by basing on the condition as in the following table to form contact holes

| Implement ation | Flowrate of process gas (sccm) | | Etching width (µm) | Pressure level for atmosphere in process chamber (mTorr) | Etching depth shallowest portion/ deepest portion, Å | | | Sectional shape of contact hole |
|---|---|---|---|---|---|---|---|---|
| example | N₂ | H₂ | | | center | middle | edge | |
| 3 (a) | 200 | 200 | 0-35 | 500 | 4500/ 5125 | 4750/ 5250 | 5250/ 5750 | Fig.5(a) |
| 3(b) | 200 | 200 | 0.30 | 500 | 4875/ 5250 | 5000/ 5375 | 5000/ 5500 | Fig. 3 (b) |
| 3(c) | 100 | 100 | 0-35 | 500 | 5000/ 5625 | 4675/ 5500 | 5000/ 5625 | Fig. 5(c) |
| 3(d) | 100 | 100 | 0.30 | 500 | 4750/ 5250 | 5000/ 5625 | 5125/ 5500 | Fig.5 (d) |

at the layer insulating film of the wafer W described earlier.

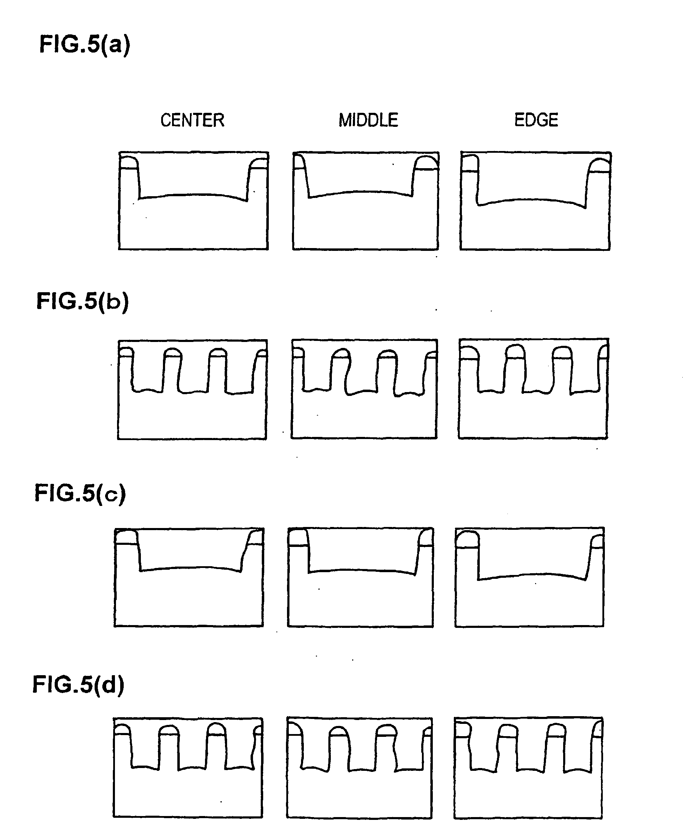

In the implementation examples 3(a)-(d) as a result, contact holes with good shapes can be formed at any flow rate, as shown in table 3 and FIG. 5. Judging from the result in this implementation example, if the pressure inside the process chamber is set at a specific - level for the atmosphere, contact holes with good shapes can be formed even when the flow rate of N₂ and H₂ is changed.

While the invention has been particularly shown and described with respect to the preferred implementation example thereof by referring to the attached drawings, the present invention is not limited to these examples.

For instance, while an explanation is given in reference to the implementation example above on an example in which a process gas is constituted by mixing N₂ and H₂, or mixing N₂, H₂ and Ar, the present invention is not limited to this example. For instance, the present invention may be implemented by adding various kinds of gasses such as O₂ and an inert gas in the process gas constituted by mixing N₂, H₂ and Ar. In other words, the present invention can be implemented using any process gas containing at least nitrogen atoms and hydrogen atoms.

In addition, while an explanation is given in reference to the individual implementation examples on an instance in which the present invention is implemented on a plane parallel plate type etching apparatus and an etching apparatus in which a magnetic field is formed, the present invention is not limited to such details. It may be adopted in any of various types of plasma etching apparatuses including an inductive coupling type etching apparatus having an electrostatic shield and a microwave etching apparatus.

Moreover, while an explanation is given above in reference to the implementation example on an example in which contact holes are formed at the layer insulating film formed at the wafer and constituting of organic material with low-dielectric constant, the present invention is not limited to this example and it may be adopted when performing any type of etching process on a layer insulating film formed at a workpiece.

According to the present invention, micro trenching can be prevented without using an etch stop. Mask selectivity is also improved.

Further according to the present invention, the process gas can be easily treated and will not easily cause greenhouse warming even if the process gas is released to atmosphere. In addition, the cost for process will not increase.

Still further according to the present invention, the control of the groove shape can be facilitated as the etching condition can be easily controlled.

### INDUSTRIAL APPLICABILITY

As explained above, the present invention may be adopted a method of etching and, in particular, it is ideal in a method of etching in which there is needed to prevent micro trenching and improve mask selectivity.

## Claims

1. A method of etching an organic film on a workpiece placed in a hermetic sealed process chamber filled with process gas, said etching being carried out through an etching mask formed on said organic film, wherein the process gas includes at least nitrogen atoms and hydrogen atoms, **characterized in that** the pressure in the process chamber is between 66 and 107 Pa (500 and 800 mTorr) and the etching is finalized before the etching goes through the organic insulating film.

2. A method of etching according to claim 1**characterized in that** the nitrogen atoms constitute N₂ and the hydrogen atoms constitute H₂.

3. A method of etching according to claim 1 or 2, **characterized in that** the process gas further includes Ar.

## Patentansprüche

1. Ein Verfahren zum Ätzen eines organischen Films auf einem Werkstück, das in einer mit einem Prozessgas gefüllten, hermetisch abgeschlossenen Prozesskammer angeordnet ist, durch eine Ätzmaske, die auf dem organischen Film gebildet ist, hindurch, wobei das Prozessgas wenigstens Stickstoffatome und Wasserstoffatome beinhaltet, **dadurch gekennzeichnet, dass** der Druck in der Prozesskammer zwischen 66 und 107 Pa (500 und 800 mTorr) beträgt und das Ätzen beendet wird, bevor das Ätzen durch den organischen Isolationsfilm geht.

2. Ein Ätzverfahren nach Anspruch 1, **dadurch gekennzeichnet, dass** die Stickstoffatome N₂ bilden und die Wasserstoffatome H₂ bilden.

3. Ein Ätzverfahren nach Anspruch 1 oder 2, **dadurch gekennzeichnet, dass** das Prozessgas weiter Ar beinhaltet.

## Revendications

1. Procédé d'attaque chimique d'un film organique sur une pièce placée dans une chambre de traitement à scellement hermétique remplie d'un gaz de traitement, ladite attaque chimique étant effectuée au travers d'un masque d'attaque chimique formé sur ledit film organique, dans lequel le gaz de traitement comprend au moins des atomes d'azote et des atomes d'hydrogène, **caractérisé en ce que** la pression dans la chambre de traitement se situe entre 66 et 107 Pa (500 et 800 mTorr) et l'attaque chimique est confirmée avant que l'attaque chimique ne traverse le film isolant organique.

2. Procédé d'attaque chimique selon la revendication 1, **caractérisé en ce que** les atomes d'hydrogène constituent N₂ et les atomes d'hydrogène constituent H₂.

3. Procédé d'attaque chimique selon la revendication 1 ou la revendication 2, **caractérisé en ce que** le gaz de traitement comprend par ailleurs de l'Ar.
